# EUROPEAN PATENT APPLICATION

(11) **EP 2 429 186 A1**
(43) Date of publication of application: **14.03.2012**
(21) Application number: 11173610.4
(22) Date of filing: 12.07.2011
(51) Int. Cl.: H04N 5/52, H03G 3/30

(54) **Broadcasting receiver and control method thereof**

(30) Priority: 13.09.2010 US 382091 P; 08.12.2010 KR 20100125037
(71) Applicant: SAMSUNG ELECTRONICS CO., LTD., Suwon-si, Gyeonggi-do (KR)
(72) Inventor: LEE, Young-jin, Suwon-si Gyeonggi-do (KR)
(74) Representative: Bruce, Alexander Richard Henry

(57) **Abstract**

A broadcasting receiver and a control method thereof which receives a broadcasting signal according to a digital video broadcasting (DVB) standard, are provided. The broadcasting receiver includes: an automatic gain adjuster which adjusts an intensity of a received broadcasting signal to a predetermined level; a frame identifier which identifies an existence or non-existence of an extended frame of the broadcasting signal; and a controller which selectively controls an operation of the automatic gain adjuster depending on the existence or the non-existence of the extended frame identified by the frame identifier. With this configuration, there are provided a broadcasting receiver and a control method thereof which prevents errors in receiving a broadcasting signal having an extended frame.

## Description

The present invention relates to a broadcasting receiver and a control method thereof, and more particularly, to a broadcasting receiver and a control method thereof which receives a broadcasting signal according to a digital video broadcasting (DVB) standard.

With the commencement of digital TV broadcasting, the European Union (EU) adopted digital video broadcasting-terrestrial (DVB-T) standards and the United States adopted advanced television system committee (ATSC) standards for terrestrial digital TV broadcasting. In particular, the EU announced second generation digital TV broadcasting system (DVB-T2) standards, according to which a transmission frame area is additionally allotted for digital video broadcasting-next generation handheld (DVB-NGH) which is called future extended frame (FEF) to provide digital TV broadcasting while the user is stationary or moving. A broadcasting signal according to the DVB-T2 standards has the FEF area empty, as the case may be, and possibly causes errors in receiving broadcasting by a broadcasting signal receiver.

Accordingly, one or more exemplary embodiments provide a broadcasting receiver and a control method thereof which selectively controls an automatic gain adjuster to adjust an intensity of a broadcasting signal depending on an existence or non-existence of an extended frame in the broadcasting signal according to DVB-T2 standards.

The foregoing and/or other aspects may be achieved by providing a broadcasting receiver including: an automatic gain adjuster which adjusts an intensity of a received broadcasting signal to a predetermined level; a frame identifier which identifies an existence/non-existence of an extended frame of the broadcasting signal; and a controller which selectively controls an operation of the automatic gain adjuster depending on the existence/non-existence of the extended frame identified by the frame identifier.

The received broadcasting signal may include a radio frequency (RF) signal, and the broadcasting receiver may further include: a converter which converts the RF signal into an intermediate frequency (IF) signal, and the automatic gain adjuster may include a first automatic gain adjuster which adjusts an intensity of the RF signal to a predetermined level and a second automatic gain adjuster which adjusts an intensity of the converted RF signal (i.e., the IF signal) to a predetermined level.

The controller may selectively control an operation of at least one of the first and second automatic gain adjusters depending on the existence/non-existence of the extended frame identified by the frame identifier.

The controller may control at least one of the first and second automatic gain adjusters to suspend the operation of one of the first and second automatic gain adjusters if the existence of the extended frame is identified by the frame identifier.

The broadcasting receiver may further include a decoder which decodes the broadcasting signal, and the frame identifier may be electrically connected to the decoder.

The frame identifier may identify whether the extended frame exists between a plurality of data frames of the decoded signal.

The broadcasting signal may include a broadcasting signal according to a digital video broadcasting (DVB) standard, and the decoder may decode a physical layer signal included in the broadcasting signal according to the DVB standard.

The foregoing and/or other aspects may be achieved by providing a control method of a broadcasting signal, the control method including: receiving a predetermined broadcasting signal; identifying an existence or non-existence of an extended frame of the received broadcasting signal by a frame identifier; and selectively controlling an operation of an automatic gain adjuster which adjusts an intensity of the received broadcasting signal to a predetermined level depending on the identified existence/non-existence of the extended frame.

The received broadcasting signal may include a radio frequency (RF) signal, and the broadcasting receiver may include a converter which converts the RF signal into an intermediate frequency (IF) signal, and the automatic gain adjuster may include a first automatic gain adjuster which adjusts an intensity of the RF signal to a predetermined level and a second automatic gain adjuster which adjusts an intensity of the converted RF signal (i.e., the IF signal) to a predetermined level.

The controlling may include selectively controlling the operation of at least one of the first and second automatic gain adjusters depending on the existence/non-existence of the extended frame identified by the frame identifier.

The controlling may include controlling at least one of the first and second automatic gain adjusters to suspend its operation if the existence of the extended frame is identified.

The control method may further include decoding of the received broadcasting signal by a decoder, and the frame identifier may be electrically connected to the decoder.

The identifying may include identifying an existence or non-existence of the extended frame between a plurality of data frames of the decoded signal.

The broadcasting signal may include a broadcasting signal according to a DVB standard, and the decoder may decode a physical layer signal included in the broadcasting signal according to the DVB standard.

The above and/or other aspects will become apparent and more readily appreciated from the following description of the exemplary embodiments, taken in conjunction with the accompanying drawings, in which:
FIG. 1 is a control block diagram of a broadcasting receiver according to an exemplary embodiment;
FIG. 2 is a detailed control block diagram of the broadcasting receiver in FIG. 1;
FIG. 3 illustrates a frame configuration of a broadcasting signal according to DVB-T2 standards; and
FIG. 4 is a control flowchart of the broadcasting receiver in FIG. 1.

Below, exemplary embodiments will be described in detail with reference to accompanying drawings so as to be easily realized by a person having ordinary knowledge in the art. The exemplary embodiments may be embodied in various forms without being limited to the exemplary embodiments set forth herein.

Descriptions of well-known parts are omitted for clarity, and like reference numerals refer to like elements throughout.

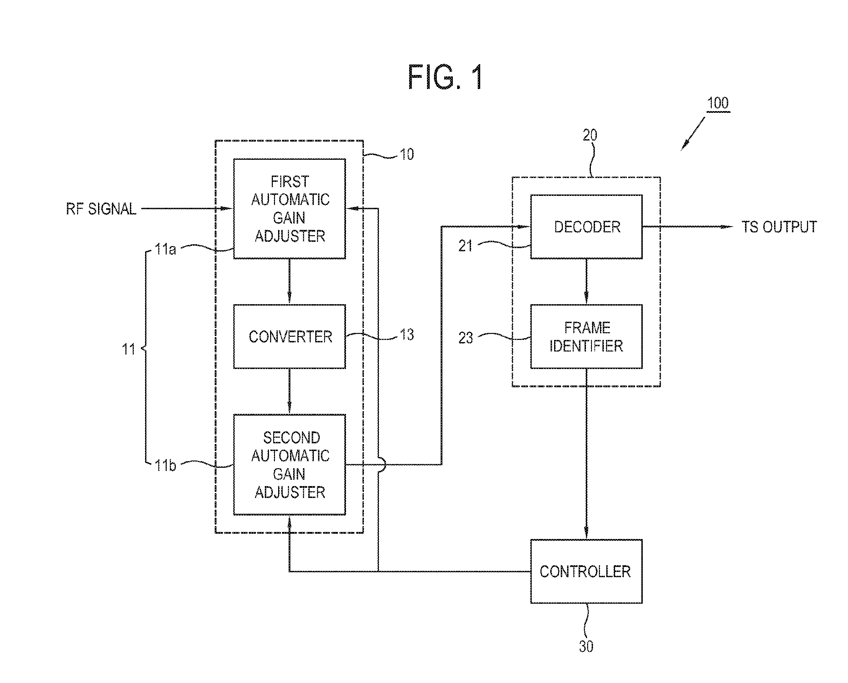

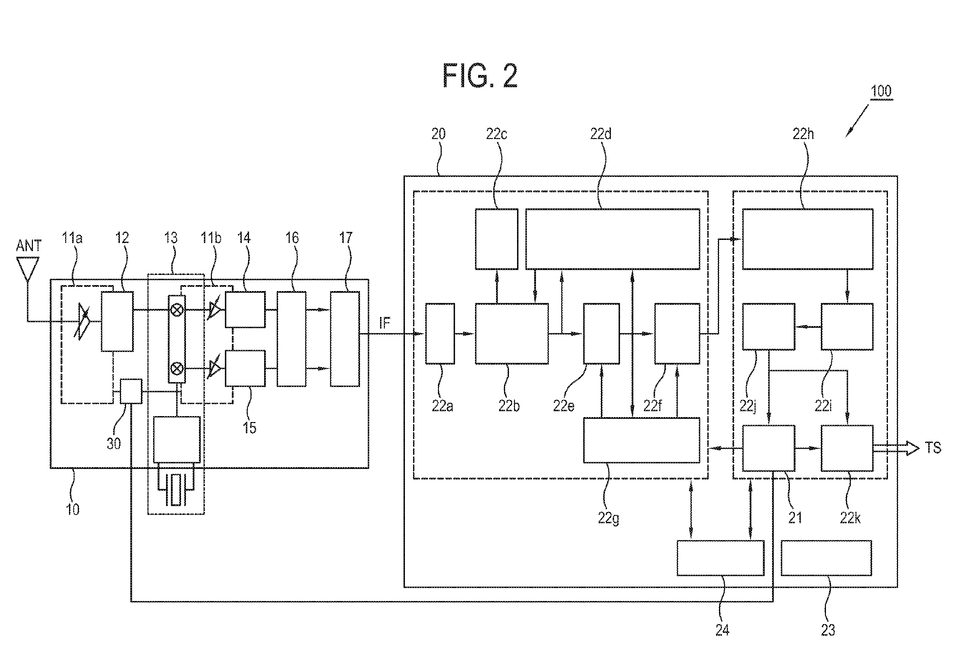

A broadcasting receiver according to an exemplary embodiment will be described with reference to FIGS. 1 and 2. FIG. 1 is a control block diagram of a broadcasting receiver according to the exemplary embodiment. FIG. 2 is a detailed control block diagram of the broadcasting receiver in FIG. 1. As shown therein, the broadcasting receiver 100 includes a radio frequency (RF) signal processor 10, a demodulator 20 and a controller 30 which controls the foregoing elements.

The broadcasting receiver 100 may receive a digital TV broadcasting signal, e.g., a broadcasting signal according to standards such as, but not limited to, digital video broadcast-handheld (DVB-H), digital video broadcast-next generation handheld (DVB-NGH), next generation digital video broadcasting-terrestrial (DVB-T2) or the like. Further, the broadcasting receiver 100 may receive a digital TV broadcasting signal according to standards which are known or are expected to be developed in the future, including, but not limited to, digital video broadcast-terrestrial (DVB-T), integrated services digital broadcasting-terrestrial (ISDB-T), advanced television systems committee (ATSC), digital multimedia broadcast-terrestrial (DMB-T), satellite digital multimedia broadcasting (S-DMB), forward link only (FLO), digital audio broadcasting (DAB) and digital radio mondiale (DRM). Accordingly, the broadcasting receiver 100 may include any type of electronic devices which receive the foregoing digital TV broadcasting signal. For example, the broadcasting receiver 100 may include a digital TV, a set-top box or a handheld electronic device.

However, the broadcasting receiver 100 is not limited thereto.

The RF signal processor 10 processes a broadcasting signal in an RF band (48MHz-860MHz) received through an antenna. The RF signal processor 10 includes an automatic gain adjuster 11 and a converter 13.

The automatic gain adjuster 11 includes a first automatic gain adjuster 11a and a second automatic gain adjuster 11b. The first automatic gain adjuster 11a adjusts an RF broadcasting signal received through the antenna to a predetermined intensity by applying a predetermined gain ratio. The RF signal with the gain adjusted is filtered by a first filter 12 (refer to FIG. 2) to allow a usable band group of the received RF signal to pass the first filter 12 and to filter a non-usable band group of the RF signal. The filtered signal is transmitted to the converter 13.

The converter 13 converts the RF signal into an intermediate frequency (IF) signal.

The converter 13 may include a mixer (not shown), an oscillator (not shown) and a phase locked loop (PLL) (not shown) to convert the RF signal into an IF signal.

The signal which passes through the oscillator is mixed with the RF signal by the mixer, and converted into the IF signal.

The second automatic gain adjuster 11b adjusts the converted RF signal (i.e., the IF signal) to a predetermined intensity by applying a predetermined gain ratio. The IF which is adjusted to the predetermined gain is transmitted to the demodulator 20 through an ADC 14 for an I signal and an ADC 15 for a Q signal and through a second filter 16 and an output interface 17.

The demodulator 20 converts the IF signal with the gain adjusted to a baseband signal for a demodulation of the signal and outputs a signal in the form of a transport stream (TS).

The demodulator 20 includes a decoder 21 and a frame identifier 23. The demodulator 20 may further include an ADC 22a (refer to FIG. 2) to convert an analog signal into a digital signal, a digital filter 22b to filter a digital signal, a dual AGC 22c as a third automatic gain adjuster, a carrier wave/timing recovery unit 22d including a carrier wave recovery unit to perform an automatic phase control and recover a carrier wave in the same phase as a modulated carrier wave from a pilot signal and a timing recovery unit to extract a timing signal from a reception signal; an FFT 22e to perform high-speed fourier transformation, an equalizer 22f to recover or compensate for a distortion and interruption in a channel, a channel estimator 22g to estimate a size and reference phase of a carrier wave, a deinterleaver 22h to convert interleaved data for time, frequency, cell and bit to data before interleaving, in particular, to process an FEC block included in a DVB-T2 signal, an LDPC decoder 22i to decode a low density parity check (LDPC) as an error-detecting code to transmit coded data, a BCH decoder 22j to decode a BCH code included in a signal, a dejitter buffer 22k to output a demodulated TS whose error is adjusted, and an FSM 24 to check and control a demodulation state of the broadcasting signal. The foregoing elements are an exemplary embodiment, and do not limit the inventive concept thereto.

The decoder 21 decodes a physical layer signal included in the broadcasting signal.

If a broadcasting signal according to the DVB-T2 standard is received through the antenna, the decoder 21 may decode a physical layer signal according to the DVB-T2 standard, particularly an L1 signal.

The frame identifier 23 may identify an existence or non-existence of the extended frame from the signal decoded by the decoder 21.

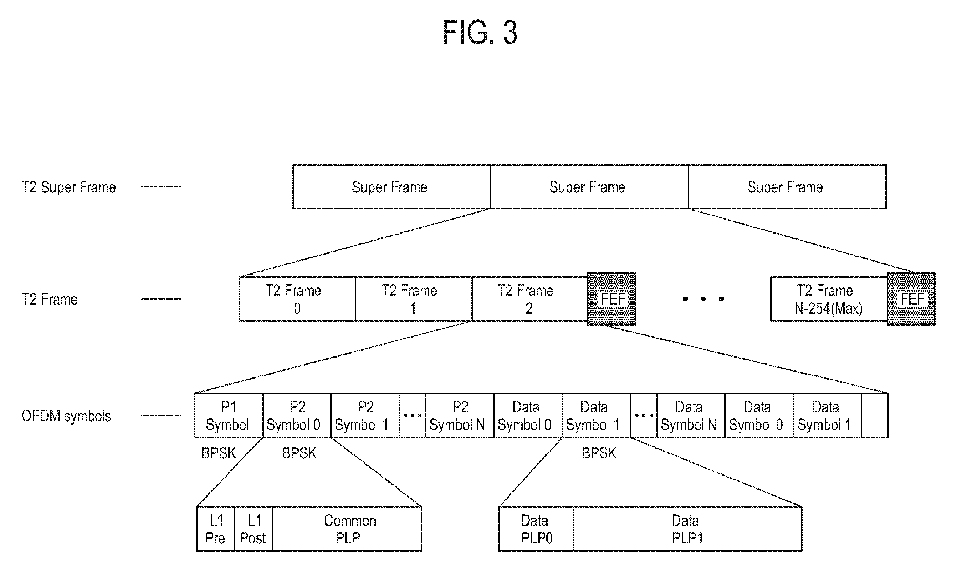

The broadcasting signal which is received according to the present exemplary embodiment includes a predetermined digital TV broadcasting signal, e.g., a broadcasting signal according to the DVB-T2 standard. The broadcasting signal according to the DVB-T2 standard is based on MPEG-2 for an image compression, and adopts COFDM modulation by a modulation of QPSK, 16 QAM, 64 QAM and 256 QAM. FIG. 3 illustrates a frame configuration of a DVB-T2 broadcasting signal.

As shown in FIG. 3, the DVB-T2 broadcasting signal includes a super frame including an extended frame (e.g. FEF) between T2 frames. Each T2 frame includes a P1 symbol consisting of a 1k OFDM symbol, a P2 symbol for DVB-T2, NGH, MIMO and MISO, a data symbol and an auxiliary symbol (not shown). The P2 symbol includes information on a physical layer of an open system interconnection (OSI) layer in the DVB-T2 system, and includes an L1 pre-signaling signal including not only information for decoding an L1 post-signaling but also information relating to size, coding and modulation such as basic information on the T2 system, an L1 post-signaling signal including detailed L1 information on the T2 system and the PLPs, and a common PLP including data shared by a plurality of PLPs transmitted following the L1 signal.

The extended frame is a part of a super frame between two T2 frames and includes a transmission frame for DVB-NGH to support mobility for a DVB-T2 broadcasting signal, which is additionally allotted for a multiple input multiple output (MIMO). No data may be transmitted as the case may be. If a broadcasting signal which does not include any data in the extended frame additionally allotted is received, the automatic gain adjuster may have an error due to a non-existence of the data in the extended frame, which may cause a distortion, flickering or the like in receiving broadcasting.

In the case of the broadcasting signal including the extended frame, the operation of the automatic gain adjuster should selectively be controlled depending on the existence or non-existence of the extended frame.

The decoder 21 decodes the received DVB-T2 broadcasting signal, and in particular, a physical layer signal (e.g. L1 signal). According to the decoding result, the frame identifier 23 may identify whether the received broadcasting signal includes the extended frame. If the extended frame exists, a logic high signal by an interrupt may be transmitted to the controller 30. If the extended frame does not exist, a logic low signal may be transmitted to the controller 30.

The controller 30 may selectively control the operation of the automatic gain adjuster 11 depending on the existence or non-existence of the extended frame identified by the frame identifier 23. The automatic gain adjuster 11 includes the first automatic gain adjuster 11a and the second automatic gain adjuster 11b. The controller 30 may selectively control the operation of at least one of the first automatic gain adjuster 11a and the second automatic gain adjuster 11b depending on the existence or non-existence of the identified extended frame.

Preferably, but not necessarily, if the frame identifier 23 identifies the existence of the extended frame, the controller 30 may control at least one of the first and second automatic gain adjusters 11a and 11b to suspend its operation. More preferably, but not necessarily, the controller 30 may control both the first and second automatic gain adjusters 11a and 11b to suspend their operations.

If the logic high signal is received from the frame identifier 23, the controller 30 controls the first and second automatic gain adjusters 11a and 11b to suspend their operations. If the logic low signal is received from the frame identifier 23, the controller 30 may control the first and second automatic gain adjusters 11a and 11b to operate in a normal manner.

If the frame identifier 23 identifies a non-existence of the extended frame, the controller 30 may control at least one of the first and second automatic gain adjusters 11 and 11b to adjust an intensity of the signal according to a predetermined gain ratio.

The controller 30 may include a switch to control the first and second automatic gain adjusters 11a and 11b. As the switch is controlled by the identification results of the frame identifier 23, the operation of the first and second automatic gain adjusters 11a and 11b may be controlled.

Otherwise, the controller 30 may be provided as a pin in the first and second automatic gain adjusters 11a and 11b to receive a signal according to the identification result from the frame identifier 23. Upon receiving the signal informing the existence of the extended frame from the frame identifier 23, the pin may hold and suspend the operation of the first and second automatic gain adjusters 11a and 11b.

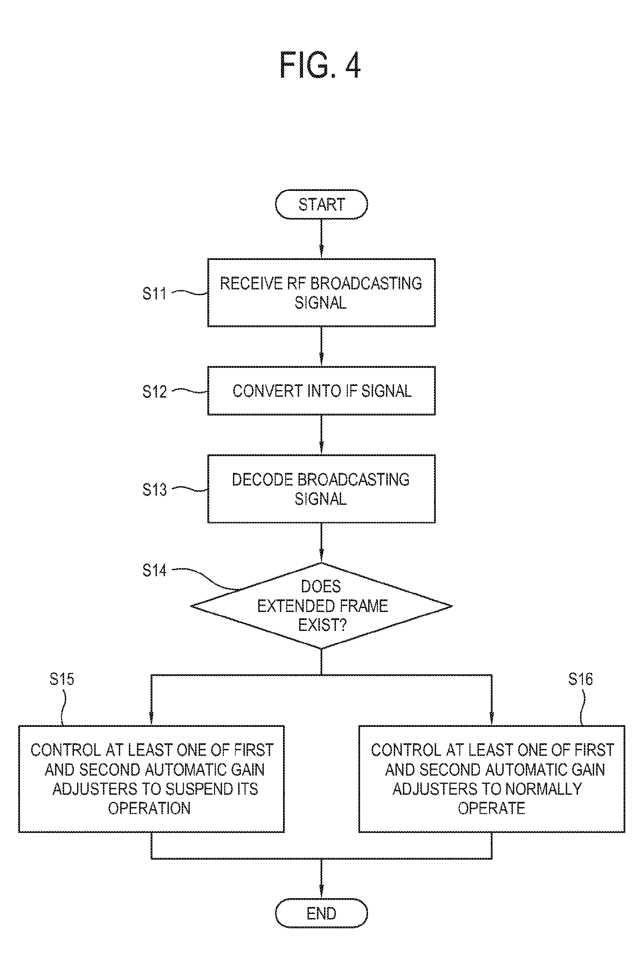

FIG. 4 is a control flowchart of the broadcasting receiver in FIG. 1.

If a predetermined broadcasting signal is received (operation S11), the received RF broadcasting signal is converted into the IF signal (S12). The converted RF signal (i.e., the IF signal) is decoded (operation S13), and the existence of the extended frame between the plurality of data frames is identified from the decoded signal (operation S14). If it is identified that the extended frame exists, the controller 30 controls at least one of the first and second automatic gain adjusters 11 and 11b to suspend its operation (operation S15). The first automatic gain adjuster 11 adjusts the intensity of the RF broadcasting signal and the second automatic gain adjuster 11b adjusts the intensity of the IF signal. If it is identified that the extended frame does not exist, the controller 30 controls at least one of the first and second automatic gain adjusters 11a and 11b to operate in a normal manner (operation S16).

As described above, a broadcasting receiver and a control method thereof according to an exemplary embodiment may selectively control an automatic gain adjuster adjusting an intensity of a broadcasting signal, depending on an existence or non-existence of an extended frame of the broadcasting signal according to a DVB-T2 standard to thereby prevent an error in receiving a broadcasting.

Although a few exemplary embodiments have been shown and described, it will be appreciated by those skilled in the art that changes may be made in these exemplary embodiments without departing from the principles of the inventive concept, the range of which is defined in the appended claims.

## Claims

1. A broadcasting receiver comprising:
an automatic gain adjuster which adjusts an intensity of a received broadcasting signal to a predetermined level;
a frame identifier which identifies an existence or non-existence of an extended frame of the broadcasting signal; and
a controller which selectively controls an operation of the automatic gain adjuster depending on the existence or non-existence of the extended frame identified by the frame identifier.

2. The broadcasting receiver according to claim 1, wherein the received broadcasting signal comprises a radio frequency (RF) signal, and further comprises:
a converter which converts the RF signal into an intermediate frequency (IF) signal, and
the automatic gain adjuster comprises a first automatic gain adjuster which adjusts an intensity of the RF signal to a predetermined level and a second automatic gain adjuster which adjusts an intensity of the IF signal to a predetermined level.

3. The broadcasting receiver according to claims 1 or 2, wherein the controller selectively controls an operation of at least one of the first automatic gain adjuster and the second automatic gain adjuster depending on the existence or non-existence of the extended frame identified by the frame identifier.

4. The broadcasting receiver according to any one of claims 1 to 3, wherein the controller controls at least one of the first automatic gain adjuster and the second automatic gain adjuster to suspend an operation of the at least one of the first automatic gain adjuster and the second automatic gain adjuster if the existence of the extended frame is identified by the frame identifier.

5. The broadcasting receiver according to any one of claims 1 to 4, further comprising a decoder which decodes the broadcasting signal, wherein the frame identifier is electrically connected to the decoder.

6. The broadcasting receiver according to any one of claims 1 to 5, wherein the frame identifier identifies whether the extended frame exists between a plurality of data frames of the decoded signal.

7. The broadcasting receiver according to any one of claims 1 to 6, wherein the broadcasting signal comprises a broadcasting signal according to a digital video broadcasting (DVB) standard, and the decoder decodes a physical layer signal in the broadcasting signal according to the DVB standard.

8. A control method of a broadcasting signal, the control method comprising:
receiving a predetermined broadcasting signal;
identifying an existence or non-existence of an extended frame of the received broadcasting signal by a frame identifier; and
selectively controlling an operation of an automatic gain adjuster which adjusts an intensity of the received broadcasting signal to a predetermined level depending on the identified existence or non-existence of the extended frame.

9. The control method according to claim 8, wherein the received broadcasting signal comprises a radio frequency (RF) signal,
the broadcasting receiver comprises a converter which converts the RF signal into an intermediate frequency (IF) signal, and
the automatic gain adjuster comprises a first automatic gain adjuster which adjusts an intensity of the RF signal to a predetermined level and a second automatic gain adjuster which adjusts an intensity of the IF signal to a predetermined level.

10. The control method according to claims 8 or 9, wherein the controlling comprises selectively controlling the operation of at least one of the first automatic gain adjuster and the second automatic gain adjuster depending on the existence or non-existence of the extended frame identified by the frame identifier.

11. The control method according to any one of claims 8 to 10, wherein the controlling comprises controlling at least one of the first automatic gain adjuster and the second automatic gain adjuster to suspend its operation if the existence of the extended frame is identified.

12. The control method according to any one of claims 8 to 11, further comprising decoding the received broadcasting signal by a decoder, wherein the frame identifier is electrically connected to the decoder.

13. The control method according to any one of claims 8 to 12, wherein the identifying comprises identifying an existence/non-existence of the extended frame between a plurality of data frames of the decoded signal.

14. The control method according to any one of claims 8 to 13, wherein the broadcasting signal comprises a broadcasting signal according to a DVB standard, and the decoder decodes a physical layer signal in the broadcasting signal according to the DVB standard.
